# EUROPÄISCHE PATENTSCHRIFT

(11) **EP 1 001 272 B1**
(45) Veröffentlichungstag und Bekanntmachung des Hinweises auf die Patenterteilung: **26.12.2007**
(21) Anmeldenummer: 99122498.1
(22) Anmeldetag: 11.11.1999
(51) Int. Cl.: G01R 31/316

(54) **Halbleiterbaustein für eine Burn-In-Testanordnung**
Semiconductor module for a burn-in test system
Module semi-conducteur pour un système de test de vieillissement accéléré

(30) Priorität: 13.11.1998 DE 19852429
(43) Veröffentlichungstag der Anmeldung: 17.05.2000
(73) Patentinhaber: Infineon Technologies AG, 81669 München (DE)
(72) Erfinder: Wirth, Norbert, 85716 Unterschleissheim (DE); Cordes, Eric, 80796 München (DE); Manyoki, Zoltan, 81739 München (DE); Savignac, Dominique Dr., 85737 Ismaning (DE)
(74) Vertreter: Müller - Hoffmann & Partner

(56) Entgegenhaltungen:
- US-A- 5 656 944
- PATENT ABSTRACTS OF JAPAN vol. 013, no. 181 (E-750), 27. April 1989 (1989-04-27) & JP 01 008639 A (MITSUBISHI ELECTRIC CORP), 12. Januar 1989 (1989-01-12)
- PATENT ABSTRACTS OF JAPAN vol. 018, no. 252 (E-1547), 13. Mai 1994 (1994-05-13) & JP 06 037159 A (TOSHIBA CORP;OTHERS: 01), 10. Februar 1994 (1994-02-10)
- PATENT ABSTRACTS OF JAPAN vol. 017, no. 101 (E-1327), 2. März 1993 (1993-03-02) & JP 04 290458 A (FUJITSU LTD;OTHERS: 01), 15. Oktober 1992 (1992-10-15)
- PATENT ABSTRACTS OF JAPAN vol. 017, no. 609 (P-1640), 9. November 1993 (1993-11-09) & JP 05 188118 A (HITACHI LTD;OTHERS: 01), 30. Juli 1993 (1993-07-30)
- PATENT ABSTRACTS OF JAPAN vol. 1997, no. 11, 28. November 1997 (1997-11-28) & JP 09 199672 A (MATSUSHITA ELECTRON CORP), 31. Juli 1997 (1997-07-31)

## Beschreibung

Die vorliegende Erfindung betrifft einen Halbleiterbaustein für eine Burn-In-Testanordnung (Einbrenn-Testanordnung), in der an den Halbleiterbaustein eine Burn-In-Spannung anlegbar ist, die höher ist als eine interne Spannung des Halbleiterbausteins, die bei Anlegen einer externen Spannung an den Halbleiterbaustein über einen im Halbleiterbaustein enthaltenen ein- und ausschaltbaren Regulator einer internen Schaltung des Halbleiterbausteines aufprägbar ist, wobei der Halbleiterbaustein durch Anlegen der Burn-In-Spannung während einer Burn-In-Zeitdauer bei ausgeschaltetem Regulator einem Alterungsprozeß zu unterwerfen ist. Ein solcher Halbleiterbaustein ist beispielsweise aus dem Dokument US-A-5 656 944 bekannt.

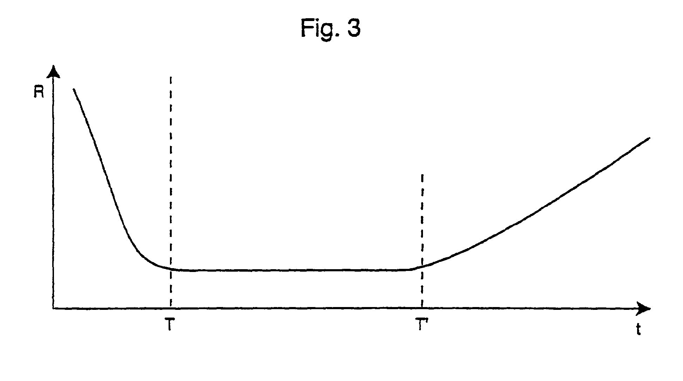

Die Ausfallrate R von Halbleiterbausteinen in Abhängigkeit von der Zeit T hat bekanntlich einen "badewannenförmigen" Verlauf: nach Fertigstellung einer großen Anzahl an sich gleicher Halbleiterbausteine fällt bis zu einer bestimmten Zeit T ein großer Anteil dieser Halbleiterbausteine aus, so daß die Ausfallrate R relativ hoch ist. Nach Erreichen dieser Zeit T bleibt die Ausfallrate R auf einem niedrigen Wert, bis nach längerem Gebrauch der Halbleiterbausteine diese ab einem Zeitpunkt T' wieder vermehrt auszufallen beginnen. Der Verlauf der Ausfallrate R in Abhängigkeit von der Zeit T ist schematisch in Fig. 3 gezeigt.

Um nun zu vermeiden, daß gerade fertiggestellte Halbleiterbausteine beim Anwender nach relativ kurzer Zeit, also vor Erreichen der Zeit T, ausfallen, werden die Halbleiterbausteine vom Hersteller einem Burn-In-Test (Einbrenntest) unterworfen, bei dem sie künstlich gealtert werden, so daß nach diesem Burn-In-Test ihr "Lebensalter" jenseits der Zeit T liegt. Durch diesen Burn-In-Test sollen also diejenigen Halbleiterbausteine aussortiert werden, die schon nach kurzer Zeit ausfallen, so daß der Anwender nur Halbleiterbausteine erhält, die bis jenseits der Zeit T gealtert sind.

Nun haben aber zahlreiche Halbleiterbausteine einen sogenannten Regulator. Dieser wandelt eine extern an den Halbleiterbaustein angelegte Spannung, beispielsweise 3,3 V, immer in eine interne Spannung um, die einen konstanten Wert hat und bei einer externen Spannung von etwa 3,3 V z.B. 2,5 V betragen kann.

Um einen Halbleiterbaustein künstlich zu altern, wird an diesen im Burn-In-Test eine höhere Spannung von beispielsweise 4,3 V angelegt, die bewirkt, daß der Halbleiterbaustein relativ rasch künstlich altert, so daß schon nach kurzer abgelaufener tatsächlicher Zeit der Alterungsprozeß die Zeit T erreicht. Ein derartiges künstliches Altern tritt aber nur ein, wenn der Regulator ausgeschaltet ist, sich also im Regulator-Aus-Testmodus befindet.

Es hat sich nun aber gezeigt, daß bei Burn-In-Tests in sogenannten dynamischen Burn-In-Testanordnungen, bei denen wechselnde Burn-In-Spannungen an den Halbleiterbaustein angelegt werden, infolge von beispielsweise Kontaktproblemen der Sokkel der Halbleiterbausteine, fehlerhafter Software und dergleichen die Halbleiterbausteine nicht zuverlässig und korrekt in den Regulator-Aus-Testmodus gelangen. In diesem Fall findet dann keine kontrollierte Voralterung durch Anlegen der Überspannung von beispielsweise 4,3 V statt. Vielmehr wird bei eingeschaltetem Regulator der Halbleiterbaustein intern nur mit 2,5 V beaufschlagt, was ihn nur geringfügig altern läßt, so daß die Zeit T beim Burn-In-Test keinesfalls erreicht wird. Im schlimmsten Fall kann es sogar vorkommen, daß der Halbleiterbaustein nicht einmal betrieben wird, sondern lediglich eine "heiße" Lagerung erfährt.

Solche Halbleiterbausteine, die keinen Burn-In-Test unterworfen wurden, verhalten sich bei weiteren Abschlußtests vor Auslieferung an den Anwender vollkommen unauffällig; sie können aber die Ausfallquote beim Anwender drastisch erhöhen, so daß die sogenannten dpm-Vorgaben, also die Ausfälle an Halbleiterbausteinen je Million Halbleiterbausteine, drastisch erhöht sind.

Dieses Problem hoher Ausfallraten beim Anwender infolge von Halbleiterbausteinen, die wegen eines eingeschalteten Regulators nicht mit der Burn-In-Spannung beaufschlagt wurden, konnte bisher praktisch nicht oder nur mit großem Aufwand durch zusätzliche Untersuchungen der Halbleiterbausteine gelöst werden.

In nicht testenden Burn-In-Anordnungen gibt es nämlich keine zuverlässigen Mechanismen, mit denen Halbleiterbausteine aufgespürt werden könnten, die wegen ihres eingeschalteten Regulators nicht mit höherer Spannung beaufschlagt wurden.

Bei einer bestehenden indirekten Methode wird der Strombedarf von beispielsweise 192 oder 256 parallel geschalteten Halbleiterbausteinen gemessen. Steigt beispielsweise dieser Strombedarf nicht stark an, so kann dies als Alarmsignal dafür gewertet werden, daß eine große Menge an Halbleiterbausteinen nicht im Regulator-Aus-Testmodus ist, also einen eingeschalteten Regulator haben. Diese Methode liefert aber nur dann ein Ergebnis, wenn ungefähr 30 % der Halbleiterbausteine nicht im Regulator-Aus-Testmodus sind, was für die Praxis ein nicht akzeptabler Wert ist, da die Ausfallraten bedeutend niedriger sind. Auch ist bei dieser Methode keine Identifikation der fehlerhaften bzw. kritischen Halbleiterbausteine möglich.

Es ist daher Aufgabe der vorliegenden Erfindung, einen Halbleiterbaustein für eine Burn-In-Testanordnung zu schaffen, bei dem ohne weiteres festgestellt werden kann, ob er beim Burn-In-Test im Regulator-Aus-Testmodus war oder nicht.

Diese Aufgabe wird bei einem Halbleiterbaustein der eingangs genannten Art erfindungsgemäß dadurch gelöst, daß in den Halbleiterbaustein ein Bauelement integriert ist, das bei anliegender Burn-In-Spannung nach Ablauf der Burn-In-Zeitdauer bei ausgeschaltetem Regulator eine andere Kenngröße als bei eingeschaltetem Regulator hat. Als Kenngröße kann dabei eine Degradation bzw. Verschlechterung des Bauelementes herangezogen werden.

In den Halbleiterbaustein wird also ein Halbleiterbauelement integriert, das bei Einschalten des Regulator-Aus-Testmodus, also bei Ausschalten des Regulators, an die im Halbleiterbaustein herrschende interne Spannung angelegt wird. Das Halbleiterbauelement ist dabei so dimensioniert, daß bei Anliegen der Burn-In-Spannung, die, wie auch im obigen Beispiel angegeben, etwa doppelt so groß wie die interne Spannung bei eingeschaltetem Regulator ist, innerhalb der Burn-In-Zeitdauer eine Degradation des Halbleiterbauelementes eintritt. Diese Degradation kann beispielsweise in einer Änderung einer Spannung, eines Stromes oder eines Widerstandswertes des Halbleiterbauelementes bestehen.

In einem folgenden Abschlußtest der Halbleiterbausteine kann die genannte Kenngröße bewertet werden, so daß in Abhängigkeit der Ergebnisse dieser Bewertung an einem Datenausgang des Halbleiterbausteines entsprechende Signale auftreten. Bei Halbleiterbausteinen, die keinem korrekten Burn-In unterworfen waren, ist das Bauelement nicht degradiert, was im Abschlußtest zu einem entsprechenden Datum am Datenausgang führt. Auf diese Weise ermittelte Halbleiterbausteine können dann für einen erneuten Burn-In-Test aussortiert werden oder als Halbleiterbausteine zweiter Wahl zum Anwender gelangen.

Anstelle eines elektrisch degradierbaren Bauelementes können auch eine oder mehrere elektrische Fuses eingesetzt werden, die durch Anlegen einer Spannung durchgetrennt werden. Das Durchbrennen der Fuses wird von einem Burn-In-Testprogramm durch einen speziellen Testmodus eingeleitet. Dieses Durchbrennen bzw. "Fusen" wird vom Halbleiterbaustein jedoch nur dann durchgeführt, wenn dieser sich im Regulator-Aus-Zustand befindet. Hierzu ist es beispielsweise möglich, ein Signal, das den Regulator-Aus-Zustand des Halbleiterbauelementes meldet, zusammen mit einem Befehlssignal zum Brennen einer Fuse einem UND-Gatter zugeführt wird: das UND-Gatter liefert nur dann ein Ausgangssignal, wenn die Fuse durchtrennt ist und der Regulator-Aus-Zustand tatsächlich vorliegt.

Durch Verwendung mehrerer Fuses ist es überdies möglich, verschiedene Burn-In-Schritte darzustellen und den zeitlichen Verlauf des Burn-In zu dokumentieren.

Durch Auslesen der Fuses im Abschlußtest kann dann eine Entscheidung über einen positiven Verlauf des Burn-In getroffen werden. Bei dem erfindungsgemäßen Halbleiterbaustein ist von wesentlicher Bedeutung, daß die Information über ein erfolgreiches/erfolgloses Burn-In im Halbleiterbaustein selbst vorhanden ist. Unabhängig von einzelnen Burn-In-Anordnungen und eventuellen Verwechslungen usw. kann im Abschlußtest sehr rasch überprüft werden, ob ein Halbleiterbaustein für eine gewisse Mindestzeitdauer im Regulator-Aus-Zustand unter Überspannung war oder nicht.

Für das elektrisch degradierbare Bauelement gilt, daß dieses bei Betrieb mit einer normalen, regulierten internen Spannung von beispielsweise 2,5 V und einer maximalen Burn-In-Zeitdauer von etwa 15 Stunden zuverlässig "überlebt" und nicht zerstört wird. Bei einem Betrieb mit der Überspannung der genannten 4,3 V wird das Bauelement aber innerhalb der Burn-In-Zeitdauer sicher über einen gewissen Grenzwert hinaus degradiert, was beispielsweise nach Ablauf einer Zielzeitdauer von 2 Stunden der Fall sein kann. Der degradierte Zustand des Bauelementes sollte ohne weiteres vom nicht-degradierten Zustand zu unterscheiden sein. Dies ist beispielsweise bei einem Bauelement möglich, das eine Struktur hat, die durch Elektromigration abreißt. Ein solches Bauelement kann aus einem mäanderförmigen Aluminiumstreifen geringer Breite bestehen, der zwischen einer Versorgungsspannung und einer Betriebsspannung des Halbleiterbausteines liegt. In einer solchen Struktur können die benötigten Ströme niedrig gehalten werden. Ein Strom mit ausreichender Stromdichte fließt von dem Aluminiumstreifen geringer Breite zu einem anderen, breit und kurz dimensionierten Teil des Bauelementes. Da die Spannung vorgegeben ist, wird die gewünschte Stromstärke für die Elektromigration durch einen entsprechend niedrigen Widerstand des Bauelementes realisiert.

Nachfolgend wird die Erfindung anhand der Zeichnung näher erläutert. Es zeigen:
- Fig. 1: ein Ausführungsbeispiel des Bauelementes bei dem erfindungsgemäßen Halbleiterbaustein,
- Fig. 2: eine UND-Verknüpfung eines Burn-Fuse-Befehlssignales mit einem Regulator-Aus-Signal und
- Fig. 3: den Verlauf der Ausfallrate R in Abhängigkeit von der Zeit T.

Die Fig. 3 ist bereits eingangs erläutert worden.

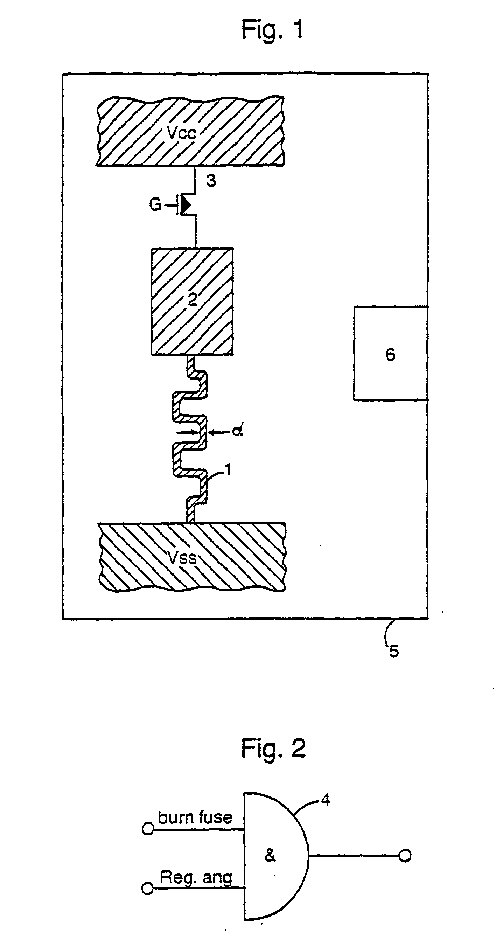

Fig. 1 zeigt einen Aluminiumstreifen 1 geringer Dicke, der zwischen Masse Vss und einem Fleck 2 aus ebenfalls Aluminium geführt ist. Dieser Fleck 2 ist über einen p-Kanal-Feldeffekttransistor 3 großer Breite an Versorgungsspannung Vcc angeschlossen. Der Aluminiumstreifen 1 und der Aluminiumfleck 2 sind offen gestaltet und ohne Schutzschicht realisiert. Der Feldeffekttransistor 3 wird an seinem Gate G eingeschaltet, wenn ein Burn-In-Test ausgeführt wird. Die Breite D des Aluminiumstreifens 1 beträgt beispielsweise einige µm.

Durch Elektromigration reißt der Aluminiumstreifen 1 nach beispielsweise 2 Stunden bei anliegender Burn-In-Spannung von 4,3 V ab, während er eine Spannung von etwa 2,5 V, also die interne Spannung bei eingeschaltetem Regulator, praktisch beliebig lang aushält. Mit anderen Worten, durch die Degradation des Aluminiumstreifens 1 kann zuverlässig festgestellt werden, ob an einem Halbleiterbaustein 5, in den das in Fig. 1 gezeigte Bauelement integriert ist, die Burn-In-Spannung angelegt wurde oder ob dieser Halbleiterbaustein 5 infolge eines eingeschalteten Regulators 6 lediglich mit der internen Spannung beaufschlagt war.

Fig. 2 zeigt ein anderes Ausführungsbeispiel mit einer Verknüpfung eines Regulator-Aus-Signales "Reg. aus" mit einem Befehlssignal zum Brennen einer Fuse "burn fuse" durch ein UND-Gatter 4: nur dann, wenn beide Signale "Reg. aus" und "burn fuse" an den Eingängen des UND-Gatters 4 liegen, also wenn der Regulator tatsächlich ausgeschaltet ist und eine dies meldende Fuse gebrannt wurde, liefert das UND-Gatter 4 ein Ausgangssignal, das anzeigt, daß der Regulator in einem bestimmten Zeitpunkt, nämlich beim Durchtrennen der Fuse, ausgeschaltet ist und eine entsprechende Fuse durchtrennt wurde. Werden mehrere derartige UND-Gatter mit entsprechenden Fuses vorgesehen, kann der Burn-In-Zeitraum durch Trennen entsprechender Fuses in zeitsequentieller Weise dokumentiert werden.

## Patentansprüche

1. Halbleiterbaustein für Burn-In-Testanordnung, in der an den Halbleiterbaustein (5) eine Burn-In-Spannung anlegbar ist, die höher ist als eine interne Spannung des Halbleiterbausteins, die bei Anlegen einer externen Spannung an den Halbleiterbaustein über einen im Halbleiterbaustein enthaltenen ein- und ausschaltbaren Regulator (6) einer internen Schaltung des Halbleiterbausteines aufprägbar ist, wobei der Halbleiterbaustein durch Anlegen der Burn-In-Spannung während einer Burn-In-Zeitdauer bei ausgeschaltetem Regulator (6) einem Alterungsprozess zu unterwerfen ist, und wobei in den Halbleiterbaustein (5) ein Bauelement (1, 2) integriert ist, das bei anliegender Burn-In-Spannung nach Ablauf der Burn-In-Zeitdauer bei ausgeschaltetem Regulator (6) eine andere Kenngröße als bei eingeschaltetem Regulator (6) hat,
**dadurch gekennzeichnet, dass**
das Bauelement (1, 2) bei ausgeschaltetem und eingeschaltetem Regulator (6) während der Burn-In-Zeitdauer an die interne Spannung angelegt ist.

2. Halbleiterbaustein nach Anspruch 1,
**dadurch gekennzeichnet, dass**
die Kenngröße eine Degradation des Bauelements (1, 2) ist.

3. Halbleiterbaustein nach Anspruch 1,
**dadurch gekennzeichnet, dass**
das Bauelement eine Fuse ist.

4. Halbleiterbaustein nach Anspruch 3,
**dadurch gekennzeichnet, dass**
ein das Brennen der Fuse meldendes Ausgangssignal nur bei ausgeschaltetem Regulator (6) erzeugt ist.

5. Halbleiterbaustein nach Anspruch 3 oder 4,
**dadurch gekennzeichnet, dass**
mehrere Fuses vorgesehen sind, die während eines Burn-In-Tests brennbar sind, wenn der Regulator (6) ausgeschaltet ist.

6. Halbleiterbaustein nach Anspruch 1 oder 2,
**dadurch gekennzeichnet, dass**
das Bauelement durch Elektromigration abreißbar ist.

7. Halbleiterbaustein nach Anspruch 6,
**dadurch gekennzeichnet, dass**
das Bauelement ein mäanderförmiger Aluminiumstreifen ist.

## Claims

1. Semiconductor module for a burn-in test arrangement in which the semiconductor module (5) can have a burn-in voltage applied to it which is higher than an internal voltage of the semiconductor module, which internal voltage can be impressed on an internal circuit of the semiconductor module when an external voltage is applied to the semiconductor module via a regulator (6) which is contained in the semiconductor module and which can be turned on and off, wherein the semiconductor module can be subjected to an aging process by applying the burn-in voltage during a burn-in time period when the regulator (6) is off, and wherein the semiconductor module (5) contains an integral component (1, 2) which, when the burn-in voltage is applied, after the end of the burn-in time period, has a different characteristic when the regulator (6) is off than when the regulator (6) is on, **characterized in that** the component (1, 2) is connected to the internal voltage during the burn-in time period when the regulator (6) is off and on.

2. Semiconductor module according to Claim 1, **characterized in that** the characteristic is degradation of the component (1, 2).

3. Semiconductor module according to Claim 1, **characterized in that** the component is a fuse.

4. Semiconductor module according to Claim 3, **characterized in that** an output signal reporting that the fuse has burnt is produced only when the regulator (6) is off.

5. Semiconductor module according to Claim 3 or 4, **characterized in that** there are a plurality of fuses which can burn during a burn-in test when the regulator (6) is off.

6. Semiconductor module according to Claim 1 or 2, **characterized in that** the component can be broken down by electromigration.

7. Semiconductor module according to Claim 6, **characterized in that** the component is a meander-shaped aluminium strip.

## Revendications

1. Module à semi-conducteur pour un dispositif de test burn-in, dans lequel il peut être appliqué au module (5) à semi-conducteur une tension burn-in qui est plus haute qu'une tension interne du module à semi-conducteur, qui, lors de l'application d'une tension externe au module à semi-conducteur, peut être imprimée par un régulateur (6) d'un circuit interne du module à semi-conducteur, régulateur qui est contenu dans le module à semi-conducteur et qui peut être mis en circuit et hors circuit, le module à semi-conducteur pouvant être soumis, par application de la tension burn-in pendant une durée burn-in alors que le régulateur (6) est hors circuit, à un processus de vieillissement et il est intégré au module (5) à semi-conducteur un composant (1, 2) qui, lorsque la tension burn-in est appliquée après l'expiration de la durée burn-in, alors que le régulateur (6) est mis en circuit, a une grandeur caractéristique autre que lorsque le régulateur (6) est en circuit,
**caractérisé en ce que**,
le composant (1, 2) est, lorsque le régulateur (6) est mis hors circuit et mis en circuit, mis à la tension interne pendant la durée burn-in.

2. Module à semi-conducteur suivant la revendication 1,
**caractérisé en ce que**,
la grandeur caractéristique est une dégradation du décomposant (1, 2).

3. Module à semi-conducteur suivant la revendication 1,
**caractérisé en ce que** le composant est un fusible.

4. Module à semi-conducteur suivant la revendication 3,
**caractérisé en ce qu'**un signal de sortie annonçant que le fusible à sauté n'est produit que lorsque le régulateur (6) est hors circuit.

5. Module à semi-conducteur suivant la revendication 3 ou 4,
**caractérisé en ce qu'**il est prévu plusieurs fusibles qui peuvent sauter pendant un test burn-in si le régulateur (6) est mis hors circuit.

6. Module à semi-conducteur suivant la revendication 1 ou 2,
**caractérisé en ce que** le composant peut être rompu par électromigration.

7. Module à semi-conducteur suivant la revendication 6,
**caractérisé en ce que** le composant est une bande d'aluminium sinueuse.
